# EUROPEAN PATENT APPLICATION

(11) **EP 4 418 304 A1**
(43) Date of publication of application: **21.08.2024**
(21) Application number: 23157190.2
(22) Date of filing: 17.02.2023
(51) Int. Cl.: H01L 21/02, B23K 26/0622, H01L 21/302

(54) **WAFER CONDITIONING**

(71) Applicant: Carl Zeiss SMS Ltd., 2015600 Misgav (IL)
(72) Inventor: OSHEMKOV, Sergey, 2166323 Karmiel (IL); GUSAROV, Alexander, 888100 Beer Ora (IL); DMITRIEV, Vladimir, 2010400 Tsurit (IL); KRUGLYAKOV, Vladimir, 23109 Migdal haEmek (IL); GORHAD, Kujan, 15235 Northern Israel, Kfar Kama; P.O. Box 786 (IL); ZEIDAN, Hani, 30056 Daliyat al-Karmel (IL)
(74) Representative: Bardehle Pagenberg Partnerschaft mbB Patentanwälte Rechtsanwälte

(57) **Abstract**

The present invention relates to a method for conditioning a bonding of substrates. The method comprising: applying a plurality of local modifications within a first substrate for facilitating bonding the first substrate to a second substrate. The invention comprises further conditioning methods, a corresponding computer program and a corresponding apparatus.

## Description

### 1. Technical field

The present invention relates to conditioning of substrates. In particular the invention relates to a method for conditioning a bonding of substrates, a method for conditioning bonded substrates, a method for bonding of substrates, as well as according apparatuses and computer programs.

### 2. Prior art

In the field of semiconductor technology various methods and devices for processing a substrate are known. For example, the substrate may comprise a (semiconductor-based) substrate in the form of a wafer wherein the processing thereof may enable the manufacturing of one or more chips. Usually, such a manufacturing of chips may require a complex integration of a plurality of processing steps applied to the substrate. For example, a processing step may comprise a material deposition onto the substrate, an etching of the substrate, an oxidation of the substrate, a lithographic patterning on the substrate, etc. For example, a processing step may also comprise bonding the substrate to another substrate (e.g., wafer to wafer bonding, wafer to die bonding wherein the other substrate may be a wafer or a die/chip).

A processing of a substrate may be usually engineered to cause a specified outcome for the substrate (e.g., a specified material deposition height, a specified etching depth, a specified lithographic overlay etc.). However, a processing of the substrate can also lead to an undesired property being induced onto the substrate. The undesired property may in turn negatively impact further processing of the substrate. Notably, the undesired property may already be present in the substrate without being induced by a particular processing thereof (e.g., the unprocessed semiconductor base material of a wafer may already comprise the undesired property). In some cases, the root cause for the undesired property may even be unknown.

To that regard, many types of undesired properties of a substrate can be possible. For example, the undesired property may comprise an undesired mechanical property of the substrate. This may comprise an undesired bending of the substrate, an undesired shape of the substrate and/or undesired mechanical stress being present in the substrate, etc. Other types of undesired properties may, for example, comprise an undesired defect and/or an undesired surface property of the substrate (e.g., an undesired surface roughness, an undesired discoloration, an undesired surface energy, etc.).

It can therefore be necessary to condition a substrate via a conditioning step to minimize or substantially remove the impact of the undesired property of the substrate. The conditioning may optimize and/or even be of high relevance to enable a defined processing of the substrate.

To that regard various types of conditioning of substrates are known in the semiconductor technology field.

For example, a conditioning of a substrate may comprise a substrate clean (e.g., a chemical clean and/or a plasma treatment) and/or the application of a thermal treatment to a substrate for a conditioning thereof. It is also known to apply a chemical mechanical polishing (CMP) process to a substrate as a conditioning thereof for further processing.

However, the currently known techniques for a conditioning of substrates are not always optimal. Therefore, there is a need to find ways to improve a conditioning of substrates.

### 3. Summary of the invention

The aspects described herein address the above need at least in part.

A first aspect relates to a method for conditioning a bonding of substrates comprising: applying a plurality of local modifications within a first substrate for facilitating bonding the first substrate to a second substrate.

The inventive concept comprises the idea that the conditioning of the substrate is implemented via a defined local modification within the substrate. Hence, a defined processing interaction within the substrate may take place as a conditioning in view of further processing of the substrate (e.g., in view of a bonding of the substrate to another substrate).

This may be considered a contrary approach to conventional conditioning processes for substrates where the modification of the substrate may be applied onto the substrate's (outside) surface. To that regard, a conventional conditioning process may comprise a defined physical and/or chemical interaction with a substrate's surface. However, in such common approaches a modification may not be applied within the substrate in a defined manner. For example, common conditioning steps for substrates in the semiconductor industry may comprise a chemical wet clean, a plasma treatment and/or a chemical mechanical polishing (CMP) of the substrate. Such common conditioning methods may be solely based on a defined chemical and/or physical interaction with the substrate's surface. For example, the interaction with the substrate's surface may comprise a liquid disposed over the surface (e.g., for a wet clean conditioning), a plasma cloud interacting with the surface (e.g., for a plasma treatment conditioning), and/or a mechanical force being applied onto the substrate's surface (e.g., for a CMP process).

Furthermore, in common conditioning approaches it may rather be the case that a global modification is applied to the substrate. For example, common conditioning processes such as a chemical wet clean, a plasma treatment, a CMP process and/or a thermal treatment may be considered as applying a global modification to a substrate. Namely, in these common conditioning approaches the defined physical and/or chemical interaction of the conditioning may only occur globally with respect to the entire substrate (e.g., the entire substrate surface). For example, the global interaction may comprise treating the entire substrate's surface in a substantially homogenous manner for conditioning (e.g., as is the case in a wet clean, a plasma treatment, a CMP process as stated above). The global interaction may also comprise a thermal treatment comprising a heating or cooling of the entire substrate in a substantially homogenous manner for a conditioning thereof (e.g., in a furnace or in a cryogenic chamber). Hence, in such common conditioning processes the defined physical and/or chemical interaction may not be localized such that it may not be possible to apply a plurality of local modifications to the substrate, let alone in a defined manner.

The common approaches for conditioning of substrates may not always lead to optimal results. For example, common approaches may have a limited conditioning effect wherein a reduction or a substantial elimination of an undesired property of the substrate may not always be possible in a defined manner. Furthermore, common conditioning approaches may not always be suitable and/or customizable in view of a specific processing and/or an (specific) characteristic of the substrate.

To illustrate an example, common conditioning approaches may be limited in the conditioning effect since an interaction may only take place with the substrate's surface. For example, a wet clean and/or a plasma treatment conditioning may thus be limited to surface effects such as a reduction of surface defects, a surface etching and/or a change in a surface energy of the substrate.

Common conditioning approaches of the substrate's surface may also be limited since only a global conditioning occurs. For a global conditioning the conditioning outcome may be limited, not easily controllable and/or not easily predictable. To illustrate an example, a thermal treatment of a substrate conditioning may comprise heating the entire substrate by applying heat to the substrate's surface. However, the conditioning outcome may not be easily predicted since, usually, merely a global qualitative substrate trend can be associated with a thermal treatment. For example, it may only be qualitatively known that the thermal treatment may induce an increase or a decrease of a substrate's mechanical stress (whereas a precise quantitative conditioning outcome, e.g., a substrate topography, may not always be derivable).

Notably, the inventors have found out that applying a plurality of local modifications within a substrate may alleviate the drawbacks of common conditioning approaches. Namely, by applying local modifications within the substrate, a high degree of freedom for conditioning of the substrate can be enabled while also extending the field of possible conditioning effects.

For example, each local modification of the plurality of local modifications within the substrate may be separately adjustable such that a highly customized and/or flexible conditioning may occur. This may significantly enhance the possibilities for a substrate's conditioning that may, for example, not be possible via common conditioning that may only globally alter the substrate. Moreover, applying the plurality of modifications within the substrate may generate one or more adaptable conditioning effects (e.g., from within the substrate) that may not be possible with common conditioning approaches as they may be based on interacting with the surface of the substrate (as stated herein).

Hence, applying a plurality of local modifications within the substrate may enable an improved mechanism to substantially remove one or more undesired properties of the substrate. The invention may thus, for example, enable a conditioning of a substrate in a highly purposeful manner for facilitating a specific processing of the substrate.

Notably, the inventors have found out that the inventive conditioning of the first substrate may, for example, be highly suitable for facilitating a bonding of the first substrate to a second substrate. As the bonding of two or more substrates usually comprises a highly complex joining process, an undesired property (e.g., an undesired mechanical property and/or an undesired surface property) of a substrate may easily lead to a poor bonding quality (e.g., at least one bonding parameter being adversely affected) or even to a completely failed bonding process. Usually, common conditioning approaches of substrates for bonding may not always suffice to condition a substrate for the complex aspects of a bonding process, as common conditioning steps may only rely on a global modification and/or a modification of the substrate's surface.

However, by applying the plurality of modification within the first substrate according to the invention a high degree of freedom of conditioning may be enabled such that the first substrate can be conditioned in a highly defined manner for facilitating even a complex bonding process of the first substrate to a second substrate.

Notably, the insight of the inventors that a plurality of modifications may be applied within a substrate for a conditioning thereof for a bonding was impeded by the prior knowledge. Namely, in the semiconductor technology field a plurality of local modifications within a substrate may usually be associated with crystallographic defects that may have one or more adverse effects on the substrate's physical characteristics (e.g., a higher mechanical stress, an irregular crystal quality, resulting surface defects, etc.). However, during bonding, a substrate may need to withstand a high physical and/or mechanical stress. Hence, local modifications within the substrate (e.g., defects within the substrate) may usually be regarded as detrimental for a bonding of the substrate to another substrate. It is thus, for example, very common to actively minimize or eliminate local modifications within the substrate for facilitating a specific processing of the substrate (e.g., a bonding thereof). For example, a crystal growth or an epitaxial process for generating the substrate is usually engineered to actively minimize crystal defects within the substrate to facilitate a specific (subsequent) processing of the substrate. However, the inventors have found out that actively applying defined local modification (e.g., in a predefined manner) within the substrate may facilitate a bonding of the substrate to another substrate (as described herein).

A local modification within a substrate (according to the invention) may comprise a defined local deviation (e.g., a defined local perturbation) within the substrate that was not present before the applying of the plurality of local modifications occurred. Notably, a defined local modification may be considered a (spatially delimited) pixel which is applied within the substrate. For example, the pixel may be spatially delimited within a local area and/or local volume within the substrate.

In an example, the local deviation may comprise a defined local mechanical deviation. For example, the defined local mechanical deviation may comprise a local density variation. The local mechanical deviation may, for example, comprise a (spatially delimited) pixel having a different density than a surrounding material of the substrate.

In an example, the defined local mechanical deviation may comprise a local stress element which may induce a local stress within the substrate. The local stress element may comprise an element that can induce a strain (e.g., a predefined strain) along one or more axes of the substrate. For example, the local stress element may be adapted to induce a predetermined first force along a first axis within the substrate and a predetermined second force along a second axis within the substrate. For example, the magnitude of the first force may be different from the magnitude of the second force. It may also be conceivable that the magnitude of the first force substantially corresponds to the magnitude of the second force. In an example, the first axis may be orthogonal to the second axis. In another example, the first axis and the second axis may span an angle different than 90°. In an example, the local density variation of the pixel may comprise an elliptical shape (e.g., an ellipsoid form) and/or a circular shape (e.g., a spherical form). In an example, the local stress element may comprise an alignment (e.g., a pixel alignment). The alignment may comprise the orientation of the first force vector (and/or the second force vector) of the local stress element with respect to a reference orientation. For example, a pixel alignment (e.g., a force vector) may be tilted in a certain angle with respect to the reference orientation. In an example, the alignment may comprise an orientation of a characteristic axis of the local density variation of the pixel (e.g., an orientation of a longer axis of the local density variation, e.g., an elliptical axis, if the local deformation comprises the shape of an ellipse). In an example, the local stress element may comprise (or be referred to as) a micro strain element.

In an example, the local modification (as described herein) may be a persistent local modification. Hence, the local modification may persist over a prolonged period of time. Notably, the extent of the persistent local modifications may change over time. For example, the extent of the strain and/or the magnitude of the (mechanical) force induced within the substrate via the local modification may reduce over time. However, the local modification may persist to such an extent that the presence of the persistent local modification within the substrate may be verified over a prolonged period of time (e.g., after 1 day, after 1 week, after 1 month, after 1 year, after 10 years, after 20 years, etc.).

Notably, a local modification (as described herein) may induce a local optical deviation. The local optical deviation may comprise a deviation in a refractive index and/or an absorption coefficient within an effective optical area around and/or within the local modification. For example, a presence of a local modification may thus be verified via an optical analysis of the substrate (e.g., via an optical measurement, e.g., a microscope).

Notably, in common approaches, the conditioning of the substrate may not persist over a prolonged period of time (e.g., only over a period of several hours, or several days). Therefore, common approaches may require that the further processing of the substrate may need to be implemented in an according time window after conditioning. This may require a complex time coupling management (e.g., in a semiconductor factory) for the processing of the substrates. However, the inventors have found out that by applying local persistent modifications within the substrate such drawbacks may be alleviated as the conditioning effect may persist over a prolonged period of time.

In an example, the applying of the plurality of local modifications within the first substrate may comprise generating a defined arrangement (e.g., an array, a matrix) of the plurality of local modifications within the first substrate. The defined arrangement may be defined via one or more arrangement parameters which may be adaptable to enable a conditioning with a higher degree of freedom in a customizable/flexible manner compared to common approaches.

For example, an arrangement parameter may comprise an arrangement pattern of the plurality of modifications within the first substrate. For example, the arrangement pattern may comprise a rectangular pattern wherein the modifications are arranged such that an envelope of the modifications within the substrate substantially resembles a rectangular shape. The arrangement pattern may also comprise a circular pattern wherein the modifications are arranged such that an envelope of the modifications within the substrate substantially resembles a circular shape. However, any other geometric pattern of the arrangement may also be conceivable (e.g., an elliptic pattern, a polygon pattern, etc.). For example, for a specific bonding process (e.g., to a specific second substrate) it may be necessary to implement a particular pattern of modifications within the first substrate for an effective conditioning.

In an example, an arrangement parameter may comprise a number of modifications which are present in the plurality of local modifications. Hence, the number of modifications within the substrate may be adaptable to enable a conditioning of the first substrate in a customizable manner (e.g., in view of a bonding of the first substrate to a second substrate). For example, for a specific bonding process (e.g., to a specific second substrate) it may be necessary to implement a certain number of modifications within the first substrate to enable an effective conditioning.

In an example, an arrangement parameter may also comprise a spacing distance between modifications of the plurality of local modifications. The spacing distance may comprise a (lateral or vertical) distance from a center of a first modification to a center of an adjacent second modification of the plurality of local modifications. Hence, the spacing between the local modifications may be adaptable to enable a conditioning in a customizable manner (e.g., in view of a bonding of the first substrate to a second substrate). For example, for a specific bonding process (e.g., to a specific second substrate) it may be necessary to implement a certain (lateral or vertical) spacing distance within the first substrate for an effective conditioning. The spacing distance may be a distance between 1 mm and 100 mm, preferably between 2 mm and 50 mm, more preferably between 5 mm and 20 mm, most preferably between 8 mm and 15 mm. For example, the spacing distance may be 10 mm. In an example, the spacing distance may be considered a lateral resolution of the pixel grid (as described herein).

In an example, an arrangement parameter may comprise a spatial order of the plurality of local modifications. For example, the plurality of local modifications may be positioned substantially along a two-dimensional plane within the substrate.

In another example, the plurality of local modifications may be positioned substantially along two or more two-dimensional planes within the substrate. Hence, the plurality of local modifications may be positioned in a three-dimensional arrangement within the substrate (e.g., a first plane having a first number of modifications and a second plane having a second number of modifications wherein the first and second plane are spaced apart by a (predetermined) spacing distance).

Furthermore, the applying of the plurality of local modifications within the first substrate may comprise that a first local modification of the plurality of local modification comprises a first local modification parameter, wherein a second local modification of the plurality of local modifications may comprise a second local modification parameter which is different from the first local modification parameter. As described herein, a local modification (e.g., also referred to as pixel) may induce one or more forces along one or more axes within the substrate. The characteristics of the locally induced (mechanical) forces may be adaptable for each modification (e.g., for each pixel) of the plurality of modifications.

Hence, the plurality of local modifications may be considered a pixel grid within the first substrate wherein each pixel may adopt a variety of states. Hence, a highly customizable conditioning of the first substrate in view of a bonding to the second substrate may occur. To illustrate an example, a pixel may comprise an (adaptable) first force vector along a first force axis, and an (adaptable) second force vector along a second force axis, wherein the first axis may be orthogonal to the second axis. Hence, a local modification parameter of a pixel may, for example, comprise an alignment of the pixel (with respect to a reference orientation), a magnitude of the first force and/or a magnitude of the second force (as described herein). Hence, every pixel may generate a defined three-dimensional, two-dimensional and/or one-dimensional mechanical effect that may be used to locally and/or globally condition the first substrate in a highly customizable manner. In another example, a local modification parameter may comprise a position of the pixel within the substrate. For example, the position may be defined via coordinates along a plane within the substrate for a predetermined depth. The position may also comprise a three-dimensional designation of pixel coordinates (e.g., a position may be defined via a cartesian coordinate system, e.g., via x-, y-, z-coordinates, and/or any other suitable coordinate system). The coordinate may, for example, address the position of the center of the pixel.

In an example, the applying of the plurality of local modifications of the first substrate may be based at least in part on a trigger (e.g., an information) that the first substrate is for bonding to a second substrate. This may enable an automized approach to implement the method. For example, the method may comprise receiving a trigger that the first substrate is for bonding to a second substrate. Based thereon a predetermined recipe of the method may be activated to perform a method according to the invention. Notably, the method may also be implemented manually (e.g., an operator may initiate the applying of the plurality of the local modifications within the first substrate in view of an information, e.g., a visual/acoustical alert, that the first substrate is for bonding to the second substrate).

In an example, the applying of the plurality of local modifications within the first substrate may be further based at least in part on a characteristic of the second substrate and/or of the first substrate.

For example, the plurality of local modifications may be predetermined and/or customizable in view of a characteristic of the first and/or second substrate. The characteristic of the first and/or second substrate may comprise a geometric property of the first and/or second substrate (e.g., a geometry as described for the second substrate herein).

For example, the first substrate may be purposefully conditioned in view of a geometric property of the second substrate. This may enable a customizable conditioning of the first substrate in view of the second substrate. Common conditioning approaches for a bonding of substrates may not necessarily consider conditioning a first substrate in view of a characteristic of a second substrate that is for bonding to the first substrate. For example, in known common global conditioning approaches (e.g., via a wet clean, a plasma treatment) the global conditioning may be performed in a constant and/or steady manner with the same process parameters being applied for conditioning (e.g., the same cleaning chemistry, the same plasma parameters (such as plasma pressure)). In such common global conditioning examples, the conditioning may not be adapted (or even adaptable) in view of a characteristic of a particular substrate. However, the invention allows a customizable conditioning in view of a particular substrate's characteristic enabling a broader range of potential conditioning effects.

According to the example, the first substrate may also be purposefully conditioned in view of a property of the first substrate (e.g., a geometric property). The conditioning of the first substrate may thus be customizable in view of its own geometric condition.

In an example, the method may comprise determining the characteristic of the second substrate (e.g., via a measurement of the second substrate). In an example, the method may comprise receiving the characteristic of the second substrate (e.g., via a wireless or wire-based data link).

In an example, the method may comprise determining and/or measuring the characteristic of the second and/or first substrate.

In an example, the applying of the plurality of local modifications within the first substrate may evoke a first target geometry of the first substrate. For example, the first substrate may initially comprise an original geometry. By applying the plurality of local modifications within the first substrate the first substrate may undergo a change from the original geometry to the first target geometry.

For example, the first target geometry may relate to a global and/or local target geometry of the first substrate. For example, the applying of the plurality of local modifications may induce a global change for the entire first substrate such that a global target geometry is evoked. In another example, the applying of the plurality of local modifications may induce a local change within a partial area and/or partial volume of the first substrate. The remaining parts of the first substrate may (in this case) not be significantly altered in their geometry.

In an example, the first target geometry may comprise a substantially flat geometry of the first substrate. A substantially flat geometry may comprise a comparatively low substrate bow and/or warpage (e.g., in the same range as a base material of the substrate). The local modifications may thus also be used to create a substantially ideal flat geometry of the first substrate.

In an example, the method comprises determining the first target geometry (e.g., which may also be referred to as deriving the first target geometry). For example, the first target geometry may be based on a simulation and/or a calculation (e.g., based on a geometry of the second substrate as described herein). In an example, the method may comprise determining the plurality of local modifications to evoke the first target geometry. For example, the determining may comprise determining what local modification parameters the pixels (of the plurality of local modifications) should have to evoke the first target geometry. The determining of the plurality of local modifications may (also) be based on a simulation which may for example comprise a simulation model of the first substrate wherein the local modifications (e.g., pixels) may be applied to the simulation model to determine what geometry will be evoked.

The desired first target geometry (and/or the local modification parameters of the pixels) may, for example, be determined in an iterative manner within the simulation.

In an example, the first target geometry may be predetermined such that if the first and second substrate are bonded at least one bonding quality parameter is improved compared to when no conditioning occurs. Hence, the invention may be used to improve the bonding quality of the first substrate with the second substrate. For example, the at least one bonding quality parameter may comprise at least one of the following: a yield of the bonding process, a bond strength, a defect density induced by the bonding, a bond interface quality. In the semiconductor technology field, such bonding quality parameters may be determined in a quantitative manner, for example, for process control purposes. The improvement in at least one bonding quality parameter may thus be determined and/or verified via split groups. For example, a first split group of one or more substrate pairs may receive a conditioning according to the invention whereas a second (reference) split group of one or more substrate pairs may not receive a conditioning according to the invention. A bonding of the one or more substrate pairs may thus be performed to determine a statistical trend of at least one bonding quality parameter in dependence on the split group. If, for example, at least one bonding quality parameter is statistically better for the first split group than for the second split group the conditioning effect of the example is met.

In an example, the method may comprise determining the first target geometry such that if the first and second substrate are bonded at least one bonding quality parameter is improved compared to when no conditioning occurs. The determining may be based on a simulation and/or a calculation (as described herein). Notably, also the bonding itself (e.g., its physical and/or chemical stress) may be simulated to determine an optimum first target geometry (e.g., such that the physical and/or chemical stress is minimized during bonding compared to when no conditioning occurs).

In an example, the herein described split group analysis method may also be used to optimize and/or determine the first target geometry. For example, it may be iteratively verified if the first target geometry induces an increase in bonding quality for various first target geometries. For example, the first target geometry may comprise a fixed first target geometry (i.e., the applying may evoke a fixed target geometry in every substrate that is for bonding to a further substrate). In such cases the split group analysis may be performed for two or more first target geometries to determine an optimum first target geometry.

In an example, the first target geometry may be based at least in part on a predetermined geometry of the second substrate. The predetermined geometry of the second substrate may comprise a measurement of a geometry of the second substrate. In an example, the method may comprise determining the geometry of the second substrate (e.g., via a measurement of the first substrate). In an example, the method may comprise receiving the predetermined geometry of the second substrate (e.g., via a wireless or wire-based data link).

In an example, the predetermined geometry of the second substrate may comprise a global geometry of the second substrate. The global geometry may comprise a geometry of the substrate that is substantially associated with an entire surface of the substrate (e.g., a front surface, a back surface and/or a side surface) and/or an entire volume of the substrate (e.g., a substrate's three-dimensional characteristics).

In an example, the global geometry of the second substrate may comprise a surface topography and/or one or more deviations of the second substrate from a substrate reference plane. For example, the surface topography may comprise a surface topography acquired via an optical topography measurement of the second substrate's front and/or back surface. The surface topography may also comprise a surface topography acquired via a profilometric measurement of the second substrate's front and/or back surface.

The one or more deviations of the second substrate from a substrate reference plane may comprise at least one of the following: a bow, a warp and/or a total thickness variation (TTV) of the second substrate. In the semiconductor field such deviations from an according reference plane are well known and may be determined in a quantified manner.

In an example, the global geometry may comprise a deviation map of the substrate indicating a deviation (e.g., a spatial deviation) for two or more positions of the second substrate with respect to an according reference plane of the second substrate. The deviation map may, for example, be used as a starting point to determine a bow, a warp and/or a total thickness variation of the second substrate (as mentioned herein). However, the deviation map (e.g., its data points), may also be used as such to adapt the applying of the plurality of local modifications.

In an example, the global geometry may comprise a signature of the deviation map. For example, it may be predetermined that the deviation map of the second substrate may comprise one or more specific signature deviations since certain types of bending of the second substrate may occur. For example, a signature of the deviation map may comprise a saddle surface, a convex surface, a concave surface and/or any other characteristic surface shape of the deviation map.

In an example, the global geometry may comprise a curvature and/or a bend of the second substrate. In an example, the deviation map of the substrate may comprise a deviation map indicating the curvature and/or bend of the second substrate for two or more positions of the second substrate.

In an example, the first target geometry of the first substrate may correspond at least in part to the predetermined geometry of the second substrate. As the applying of the plurality of modifications within the first substrate may enable generating a variety of (customizable) first target geometries the evoked first target geometry can be matched (at least in part) to the predetermined geometry of the second substrate. For example, it may be conceivable that the first target geometry of the first substrate corresponds to a partial area and/or a partial volume of the predetermined geometry of the second substrate.

To illustrate an example, the predetermined geometry of the second substrate may comprise a deviation map showing (spatial) deviations for a plurality of positions of the second substrate. The first target geometry may thus be determined such that at least an according deviation map of the first substrate corresponds at least in part to the deviation map of the second substrate. For example, the first target geometry may be determined such that a center region of the first target geometry substantially corresponds to a center region of the predetermined geometry (as may be verified via a deviation map). For example, the first target geometry may be determined such that an outer edge region of the first target geometry substantially corresponds to an outer edge region of the predetermined geometry. In another example, the first target geometry may be determined such that substantially the entire first target geometry corresponds to the entire predetermined geometry.

In an example, the method of the first aspect may further comprise applying a plurality of local modifications within the second substrate. Notably, since the first substrate can be for bonding to the second substrate, the latter may be conditioned as well for facilitating a bonding of the first substrate to the second substrate.

To that regard, every aspect described for the conditioning of the first substrate may be accordingly applied to the conditioning of the second substrate. For example, the applying of the plurality of local modifications within the second substrate may be based at least in part on a characteristic of the first substrate.

Notably, the sequence of applying of the plurality of local modifications within the second substrate may not be necessarily limited. For example, the applying of the plurality of local modifications within the second substrate may occur before, after or during the applying of the local modifications within the first substrate.

In an example, the applying of the plurality of local modifications with the second substrate may evoke a second target geometry of the second substrate.

In an example, the applying of the plurality of local modifications within the second substrate may be based at least in part on a predetermined geometry of the first substrate. Hence, (even if a first target geometry is evoked) the original geometry of the first substrate may be considered when applying the plurality of local modifications within the second substrate. The predetermined geometry of the first substrate may comprise a global geometry of the first substrate. In an example, the global geometry of the first substrate may comprise a surface topography and/or one or more deviations of the first substrate from a substrate reference plane (as described herein for the global geometry of the second substrate).

In an example, the second target geometry may be predetermined such that if the first and second substrate are bonded at least one bonding quality parameter is improved compared to when no conditioning occurs.

In an example, the second target geometry may be based at least in part on the first target geometry or vice versa.

For example, the first target geometry may correspond at least in part to the second target geometry (or vice versa). In one example, the first substrate and the second substrate may be adapted such that they are both substantially flat. In this case at least one substrate may have, for example, a comparatively lower bow or warpage than before the applying of the local modifications within the first and/or second substrate. In another example, the first substrate and the second substrate may be adapted such that they are both substantially curved or bend. In this case at least one substrate may have, for example, a comparatively higher bow or warpage than before the applying of the local modifications within the first and/or second substrate.

In an example, the first target geometry may be different than the second target geometry such that if the first and second substrate are bonded at least one bonding quality parameter can be improved compared to when no conditioning occurs. It may be conceivable that the bonding can be facilitated by generating a predetermined mismatch for the first and second target geometry such that the bonding quality is improved. This may be due to the high physical and/or chemical stress during bonding wherein a predetermined mismatch may actively induce a facilitation of the bonding of the substrates. In an example, the first and second target geometries that improve at least one bonding quality parameter may be determined or verified via a split group analysis (as described herein). In another example, the different first and second target geometries may be based at least in part on a simulation.

In an example, the method of the first aspect further may comprise sending a target geometry of at least one of the substrates to a device for further processing of at least one of the substrates, particularly a bonding device for bonding the first and second substrates. For example, the bonding device may consider the target geometry of at least one of the substrates for bonding the first substrate to the second substrate. This may enable to make a bonding device aware of the conditioning implemented via a method according to the invention. For example, the bonding device may adapt one or more bonding process parameters based on the target geometry of at least one of the substrates.

In an example, the applying the plurality of local modifications within the first and/or second substrate may be adapted such that, when the first and second substrates are arranged in a bonding position, at least one local bonding area of the first substrate and a corresponding local bonding area of the second substrate have substantially a same curvature. For example, the bonding position may comprise that the first and second substrate are arranged on top of each other. For example, the corresponding bonding areas may comprise opposing and/or adjacent areas of the first and second substrate in the bonding position. The bonding position may comprise that at least one intermediate (bonding) material is present between the two substrates.

When ensuring that corresponding bonding areas of the first and second substrate have substantially a same curvature (e.g., a local curvature along one or more axes) a bonding may be improved as an interlocking and/or improved geometric matching of the bonding areas may be ensured. A same curvature for corresponding bonding areas may enable a key-lock-principle wherein, for example, the lower surface of the upper substrate substantially matches the upper surface of the lower substrate in the bonding position. When structured patterns are present on one of the substrates a curvature of corresponding bonding areas may comprise a curvature that is defined via an envelope covering or more structured patterns.

With such an approach, air gaps and/or a thickness variation of an intermediate (bonding) layer between the substrates can be minimized which may improve at least one bonding quality parameter.

In an example, the applying the plurality of local modifications within the first and/or second substrate may be adapted such that, when the first and second substrates are arranged in a bonding position, a structure of the first substrate is substantially aligned to a corresponding structure of the second substrate. For example, without the inventive conditioning the first and second substrates may be bent such that when they are positioned in a bonding position corresponding structures (e.g., to be bonded to each other) may not be substantially aligned. The inventive method may thus enable facilitating an alignment of the substrates for bonding via the customizable conditioning with a high degree of freedom. For example, the conditioning may be used to facilitate the overlay of alignment marks of the substrates.

In an example, the applying of the plurality of local modifications within the first substrate may evoke a (predetermined) position correction of least one structure of the first substrate. Thus, the inventive method may not be limited to a conditioning effect that only adapts a (local or global) bending of the substrate as described herein (e.g., adapting a warp, a bow, a topography, etc.). Also, a second conditioning effect may be evoked that comprises a precise local position correction of at least one structure of the first substrate. This may be enabled, due to the high degree of freedom for the applied pixels, wherein each pixel may induce a freely customizable effect (e.g., via different forces along different axes of the substrate). To that regard a change of the substrate's topography (i.e., a first conditioning effect) may be interleaved with a local position correction of a structure (i.e., a second conditioning effect). However, also only a position correction may be implemented as a conditioning.

For example, the position correction may comprise an overlay correction. The overlay correction may comprise a pattern-to-pattern alignment error that may result from a lithographic overlay error and/or other pre-processing deviations of the first substrate. Notably, the method may comprise determining (e.g., measuring) the overlay error and/or receiving the overlay error. For example, the method may comprise determining (or receiving) a position of a structure wherein the position may be compared to a target position of the structure. In an example, the position correction may be applied for a plurality of structures, for example, for structures of the entire first substrate to correct the overlay error globally for the entire first substrate.

In an example, the position correction may be applied to the second substrate.

In an example, the applying of the plurality of local modifications may comprise applying one or more pulses of electromagnetic radiation to the corresponding substrate to cause the corresponding plurality of local modifications within that substrate. For example, the electromagnetic radiation may be focused within (or onto) the first substrate to cause local modifications within the first substrate and/or the electromagnetic radiation may be focused within (or onto) the second substrate to cause local modifications within the second substrate. In an example, a local modification may be evoked in an effective area of a focus of the electromagnetic radiation.

The source of the electromagnetic radiation may comprise a laser. The wavelength of the electromagnetic radiation (e.g., a laser wavelength) may comprise a wavelength between 1 µm and 20 µm. In an example, the electromagnetic radiation may comprise a wavelength (preferably) between 1 µm and 15 µm, (preferably) between 1 µm and 12 µm, (preferably) between 1 µm and 8 µm, (preferably) between 1 µm and 3 µm and/or (preferably) between 1 µm and 2 µm.

In an example, the electromagnetic radiation may comprise a wavelength between 1000 nm and 2000 nm. For example, the wavelength may comprise a wavelength of 1060 nm. In another example, the wavelength may comprise a wavelength of 1550 nm.

The pulse duration of one of the one or more pulses of the electromagnetic radiation may comprise a duration between 1 femtosecond (fs) and 100 microseconds (µs). In an example, the pulse duration may comprise a duration between 100 fs and 1 µs, (preferably) between 500 fs and 500 ns, (preferably) between 600 fs and 300 ns, (preferably) between 700 fs and 200 ns, (preferably) between 800 fs and 100 ns.

By adapting one or more optical characteristics of the electromagnetic radiation and/or a focus property thereof a characteristic of a local modification (i.e., a pixel) may be adapted. The adapting of the electromagnetic radiation may be performed via an optical setup that may optically influence the electromagnetic radiation. For example, the optical setup may comprise one or more optical elements (e.g., such as a lens, a beam shaping element, a wave shaping element, a focusing element, a diffractive optical element, a beam splitter, etc.) that may be controlled to induce a specific characteristic of a pixel. For example, by controlling the properties of the electromagnetic radiation a local modification parameter of a pixel (e.g., an alignment of the pixel, a magnitude of the first and/or the second force of the pixel) may be precisely controlled.

In an example, a local modification parameter of a pixel may comprise a characteristic of a pixel as described in US 20170010540 (with a pixel being termed therein an expansion area or a deformation, for example). Notably, in Fig. 8 and Fig. 9 of US 20170010540 the concept of a pixel (as, for example, described herein) is shown, indicating the magnitude of the expansion (of the pixel) versus its direction in space.

In an example, US 20170010540 may be regarded as a technology platform for the present invention. The local modifications may be adapted as described therein for a different purpose. Thus, the present invention may comprise using this technology platform to implement the herein described aspects for conditioning a substrate (e.g., a bonding of substrates). For example, the plurality of modifications may be adaptable and/or controllable in a similar fashion as described for US 20170010540. For example, a local modification parameter of a pixel may be adapted by adapting a beam shape of the electromagnetic radiation (e.g., a laser pulse) as described in US 20170010540. In an example, US 20170010540 is incorporated herein in its entirety by reference.

In an example, the method may further comprise performing a calibration, wherein the calibration comprises that the plurality of local modifications is applied within a calibration substrate. The calibration may further comprise determining a characteristic of at least one modification of the plurality of local modifications and/or a geometry of the calibration substrate. Based on these calibration results the applying of the plurality of local modifications may be adapted for a conditioning as described herein.

In an example, the conditioning may be performed before the bonding of the first and second substrates occurs. The method may thus be applied as a pre-conditioning of the bonding.

In an example, the conditioning may be performed after the bonding of the first and second substrates has occurred. The method may, for example, be applied as a post-conditioning of the bonding to an already bonded substrate pair, wherein the bonded substrate pair comprises the first and second substrate. For example, this may enable an improved relaxation of the bonded first and second substrates after bonding. Furthermore, it may enable correcting errors that were induced during bonding (e.g., an undesired substrate bending or an undesired positioning error of a structure).

Notably, the conditioning of the bonded first and second substrate may also be performed as a pre-conditioning for a further processing of the bonded substrate pair comprising the first and second substrates. For example, the further processing may comprise a subsequent lithographic process/patterning, a thinning (e.g., grinding and/or etching) and/or a measurement of the bonded substrate pair. For example, a first and/or second target geometry may be evoked (as described herein) to facilitate the further processing of the bonded first and/second substrate. For example, the bonded substrate pair (comprising the first and second substrate) may be conditioned such that the bonded substrate pair comprises a substantially flat geometry (as described herein).

In an example, the method may comprise the step of bonding the first and second substrates. Hence, the method of the first aspect may not be limited to a conditioning of the substrate but may also comprise the bonding of the first substrate to the second substrate as well.

In an example, during the bonding one or more bonding process parameters may be based at least in part on the conditioning (as described herein). This may enable a precise bonding in view of the conditioning according to the invention. For example, during bonding one or more bonding process parameters may be based at least in part on the target geometry of the first (and/or second) substrate.

In an example, the first substrate may comprise a wafer. The wafer may comprise a semiconductor-based wafer (e.g., a wafer comprising a semiconductor, e.g., silicon, gallium nitride, silicon carbide, gallium arsenide, etc.). The wafer may be in a substantially circular shape. In example, the wafer diameter may comprise a diameter between 1 inch and 24 inches. For example, the wafer diameter may comprise a diameter of substantially 300 millimeters (e.g., 12 inch). In another example, the wafer diameter may comprise a diameter of substantially 200 mm (e.g., 8 inch). In another example, the wafer diameter may comprise a diameter of substantially 150 mm (e.g., 6 inch). However, any other wafer dimension may be suitable for the herein described method.

In an example, the second substrate may also comprise a wafer (e.g., with characteristics as described for the first substrate). Hence, the according invention may be used to condition a wafer-to-wafer bonding.

In another example, the second substrate may be a chip and/or a die. In such an example, the chip and/or the die may comprise a smaller diameter than the first substrate. In another example, the second substrate may be a chip and/or a die, wherein the first substrate may be a wafer (as described herein). Hence, the according invention may be used to condition a wafer-to-die and/or a wafer-to-chip bonding. In an example, when the second substrate may be a chip and/or a die, only the first substrate may be conditioned (as described herein).

A second aspect relates to a method for conditioning of a first substrate, comprising: receiving a second characteristic of a second substrate; determining a plurality of local modifications to be applied within the first substrate based at least in part on the second characteristic. The local modifications may for example be determined such as to facilitate bonding of the first and second substrates.

In some examples, the method according to the second aspect may further comprise receiving a first characteristic of the first substrate and receiving a second characteristic of the second substrate. The step of determining the plurality of local modifications may be based at least in part on the first and/or the second characteristic, e.g., to facilitate bonding of the first and second substrates.

For example, the second aspect may comprise the calculation of the pixels and their local modification parameters. The method of the second aspect may be performed on a computing unit which may be configured to receive and send data to perform the herein described method.

Notably, every feature described for the first aspect (or any other herein described aspect) may be comprised as a feature of the method according the second aspect (if applicable and vice versa). For example, the method of the second aspect may comprise any method step as described for the method of the first aspect.

In an example, a characteristic of the first and/or second substrate may comprise a geometry of the first and/or second substrate, respectively (as described herein).

In an example, the method of the second aspect may further comprise deriving a first target geometry of the first substrate to facilitate bonding of the first and second substrates, wherein the plurality of local modifications to be applied within the first substrate are determined to evoke the first target geometry for the first substrate.

In an example, the method of the second aspect may further comprise determining a plurality of local modifications to be applied within the second substrate to facilitate bonding of the first and second substrates based at least in part on the first characteristic and/or the second characteristic.

In an example, the method of the second aspect may further comprise deriving a second target geometry of the second substrate to facilitate bonding of the first and second substrates, wherein the plurality of local modifications to be applied within the second substrate are determined to evoke the second target geometry for the second substrate.

A third aspect relates to a method for conditioning bonded substrates comprising: applying a plurality of local modifications within a first substrate which is bonded to a second substrate. The method of the third aspect may thus relate to a bonded substrate pair wherein the substrate pair comprises the first substrate and the second substrate. The method of the third aspect may comprise features described herein for the according example of the first aspect (that relates to performing the conditioning after the bonding of the first and second substrates has occurred). Notably, every feature described for the first and/or second aspect (or any other herein described aspect) may be comprised as a feature of the method according the third aspect (if applicable).

For example, the method of the third aspect may comprise at least one step of a method of the first and/or second aspect.

A fourth aspect relates to a method for bonding of a first substrate and a second substrate comprising: adapting one or more bonding process parameters based at least in part on a conditioning of the bonding according to a method of the first, second and/or third aspect (or any other herein described aspect).

Notably, every feature described for the first, second and/or third aspect (or any other herein described aspect) may be comprised as a feature of the method according the fourth aspect (if applicable and vice versa).

A fifth aspect relates to a method for conditioning a substrate comprising:
applying a plurality of local modifications within a first substrate based at least in part on a characteristic of a second substrate. Notably, every feature described for the first second, third and/or fourth aspect (or any other herein described aspect) may be comprised as a feature of the method according the fifth aspect (if applicable and vice versa).

In an example of the method according to the fifth aspect, the first substrate may be conditioned in view of the second substrate as it may not always be necessary to conditioning a substrate in view of another processing (e.g., a bonding). For example, the first substrate may be conditioned in view of a characteristic of the second substrate for calibration purposes.

For example, the second substrate may have already received a conditioning. Hence, based on a characteristic of the second substrate (e.g., as described herein, e.g., a geometry) the conditioning of the first substrate may be adapted, for example, to achieve an optimized conditioning effect.

A sixth aspect relates to a computer program comprising instructions for performing a method according to any method of the first, second, third, fourth and/or fifth aspect, when the computer program is executed.

In an example, the computer program may implement a step to determine the plurality of local modifications to be applied within the first and/or second substrate for facilitating the bonding of the first and second substrates.

A seventh aspect relates to an apparatus for conditioning a bonding of substrates comprising: means for applying a plurality of local modifications within a first substrate for facilitating bonding of the first substrate to a second substrate; a control unit configured to control the apparatus to perform a method according to any method of the first, second, third, fourth and/or fifth aspect. The control unit may, for example, comprise a computer, a computing entity, a processor that may adapt one or more system parameters of the apparatus (e.g. system parameters of an optical setup of the apparatus) to cause the apparatus to perform the herein described methods. In an example, the control unit may comprise a storage wherein the storage may comprise the computer program according to the sixth aspect. The apparatus may thus be configured to execute the computer program of the sixth aspect. This may enable the control unit to control the apparatus to perform a method as described herein.

In an example, the apparatus may comprise means for determining the plurality of local modifications within a substrate for a herein described method. The means for determining may be comprised in a control unit (and may comprise an according computer program). For example, the means for determining may be configured to determine the plurality of local modification within the first substrate for facilitating a bonding of the first substrate to a second substrate (e.g., for performing a method according to the first aspect or any other herein described aspect). In an example, the means for determining may be configured to determine the plurality of local modification within the first substrate based at least on a characteristic (or parameter) of the second substrate.

For example, the means for determining may determine via a simulation and/or a calculation what modification parameter a pixel of the plurality of local modifications should have such that a first target geometry of the first substrate is evoked, wherein the first target geometry may be based on a characteristic of the second substrate. The means for determining may thus also determine a first target geometry via a simulation and/or a calculation in view of, for example, a predetermined geometry and/or position of a structure of the second substrate.

In an example the control unit may be configured to receive information that the first substrate is for bonding to the second substrate and to control the apparatus to perform the method based at least in part on the information. The information may comprise a trigger signal, a flag and/or a manual input.

In an example, the means for applying may comprise: a source for generating one or more pulses of electromagnetic radiation; a first element for focusing a beam of the electromagnetic radiation onto a predetermined focusing depth within the first substrate.

In an example, the means for applying may further comprise at least one of the following: a first element for adapting a wavefront of the electromagnetic radiation; means for splitting the beam of electromagnetic radiation into a plurality of split beams.

In an example, the apparatus may further comprise means for positioning the first substrate to control a local position of at least one local modification of the plurality of local modifications. For example, the positioning may comprise a rotation of the first substrate (via the means for positioning). For example, the first substrate may be positioned in a first position wherein a first set of local modifications is applied to the first substrate within a first application field (e.g., within a delimited area or volume of the first substrate). Subsequently, the first substrate may be rotated (e.g., via a rotation of the means for positioning) to a second position where a second set of local modifications is applied to the first substrate within a second application field. Hence, the plurality of local modifications may be distributed/positioned within the first substrate by rotating the substrate. This may enable that the positioning of the interactions evoking the local modifications (e.g., a positioning of the optical path of the one or more laser pulse focused into the first substrate) may be reduced in complexity.

Notably, the means for positioning the first substrate may not be necessarily limited to a rotation. For example, the means for positioning may position the first substrate via a lateral movement of the substrate wherein the lateral movement may be along one or more axes. The lateral movement may be combined with a rotational movement. By enabling a lateral movement in combination with a rotational movement a local modification may be positioned onto (substantially) any position within the first substrate. In an example, the means for positioning may be adapted to perform a rotation of the first substrate in combination with a lateral movement thereof along one or more axes wherein the lateral movement may comprise a movement in opposite directions of the axis. Hence, by rotating the first substrate and a lateral movement sets of the local modifications may be applied within a spiral pattern (as described herein).

In an example, the means for positioning may enable a three-dimensional positioning of the substrate within the apparatus. For example, the means for positioning may thus enable a lateral movement (along one or more axes), as well as a vertical movement of the first substrate within the apparatus.

The herein described lateral movement and/or the rotational movement of the first substrate may comprise a movement of the substrate within a plane (that may be spanned or be parallel to the first substrate's surface).

In an example, the means for positioning may be configured to position a bonded substrate pair comprising the first substrate being bonded to the second substrate. For example, the means for positioning may be adapted to securely clamp a bonded substrate pair. For example, the means for positioning may comprise a chucking system that is capable to securely fixate the bonded substrate pair while a method according to one of the herein described aspects is performed. Namely, a common means for positioning a wafer may not always be suitable to safely position a bonded substrate pair.

In an example, the means for positioning may comprise a chuck and/or a stage. For example, the chuck may be adapted to be in contact with the bonded substrate pair and to securely fixate it. In an example, the chuck may be coupled to the stage to follow its movement, wherein the stage may be adapted to perform a lateral movement, a rotational movement and/or a three-dimensional movement as described herein. In another example, the chuck may perform a lateral movement, a rotational movement and/or a three-dimensional movement as described herein (wherein the stage may follow the movement of the chuck or wherein, for example, no stage is present).

Notably, the characteristics of the first substrate and/or the methods (or interactions) applied to the first substrate as described herein may also be characteristics of the second substrate and/or comprised herein as methods (or interactions) applied to the second substrate. Moreover, the characteristics of the second substrate and/or the methods (or interactions) applied to the second substrate as described herein may also be characteristics of the first substrate and/or comprised herein as methods (or interactions) applied to the first substrate.

It is noted that the method steps (or computer program steps) as described herein may comprise all aspects described herein, even if not expressly described as method steps but rather with reference to an apparatus (or device or system). Moreover, the apparatus (or systems or devices) as outlined herein may comprise means for implementing all aspects as outlined herein, even if these may rather be described in the context of method steps (or computer program steps).

The methods outlined herein may be computer-implemented.

Whether described as method steps, computer program and/or means, the functions described herein may be implemented in hardware, software, firmware, and/or combinations thereof. If implemented in software/firmware, the functions may be stored on or transmitted as one or more instructions or code on a computer-readable medium. Computer-readable media include both computer storage media and communication media including any medium that facilitates transfer of a computer program from one place to another. A storage medium may be any available media that can be accessed by a general purpose or special purpose computer. By way of example, and not limitation, such computer-readable storage media can comprise RAM, ROM, EEPROM, FPGA, CD/DVD or other optical disk storage, magnetic disk storage or other magnetic storage devices, or any other medium that can be used to carry or store desired program code means in the form of instructions or data structures and that can be accessed by a general-purpose or special-purpose computer, or a general-purpose or special-purpose processor. The control unit as described herein may also be implemented in hardware, software, firmware, and/or combinations thereof, for example, by means of one or more general-purpose or special-purpose computers, and/or a general-purpose or special-purpose processors.

### 4. Short description of the figures

- **Fig. 1**: shows two examples for a conditioning of a substrate via local modifications according to the invention wherein the conditioning evokes a target geometry of the substrate.
- **Fig. 2**: shows two examples for a conditioning of a substrate via local modifications according to the invention wherein the conditioning evokes a positioning correction of a structure of the substrate.
- **Fig. 3**: shows a flow chart of an exemplary (conditioning) method of the invention wherein the conditioning is performed as a pre-conditioning for a bonding of substrates.
- **Fig. 4**: shows two examples for a pre-conditioning of substrates for a bonding of the substrates.
- **Fig. 5**: shows a flow chart of an exemplary (conditioning) method of the invention wherein the conditioning is performed as a post-conditioning after a bonding of substrates has occurred.
- **Fig. 6**: shows an example for a post-conditioning of substrates according to the invention after a bonding of substrates has occurred.
- **Fig. 7**: shows a flow chart of two exemplary (conditioning) methods according to the invention wherein the conditioning of substrates is performed before and after a bonding of the substrates.
- **Fig. 8**: shows an example for a post-conditioning of substrates according to the invention wherein a pre-conditioning of the substrates has occurred.
- **Fig. 9**: shows experimental results of a conditioning of a substrate according to the invention.
- **Fig. 10**: shows further experimental results of a conditioning of a substrate according to the invention.
- **Fig. 11**: shows further experimental results of a conditioning of a substrate according to the invention.
- **Fig. 12**: shows a first example of an apparatus according to the invention.
- **Fig. 13**: shows a second example of an apparatus according to the invention.
- **Fig. 14**: shows a third example of an apparatus according to the invention.

### 5. Detailed description of the figures and embodiments

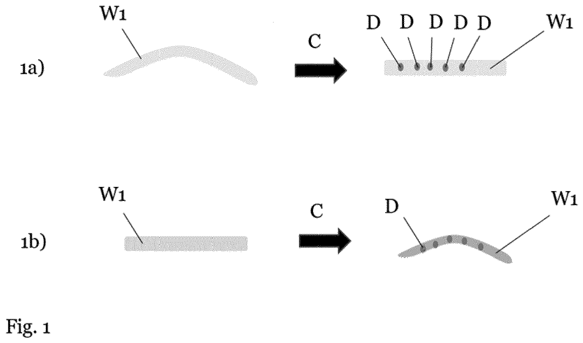

Fig. 1 shows two schematic examples for a conditioning of a substrate via local modifications according to the invention wherein the conditioning evokes a target geometry of the substrate. The upper fig. 1a discloses an example wherein the conditioning of a substantially curved (or bend) substrate W1 is performed according to the invention. In this example, the substrate W1 may be a (semiconductor-based) first wafer W1. The first substrate W1 may have a substantial wafer bow and/or wafer warpage as indicated by the schematic curved shape in fig. 1a. For example, the conditioning may comprise applying a plurality of local modifications D within the first wafer W1. The plurality of local modifications D may persist within the first wafer over a prolonged period of time (as described herein) such that the conditioning effect may also persist over a prolonged period of time. In this example, the plurality of local modifications is applied (i.e., generated) within the first Wafer W1 such that the shape/geometry of the first wafer W1 is transformed via bending from its originally curved shape/geometry to a substantially flat shape/geometry. For example, the plurality of local modifications D may be applied such that the wafer bow and/or wafer warpage of the first wafer W1 is reduced after the conditioning C.

The upper fig. 1b discloses an example wherein the conditioning C of a substantially flat substrate W1 is performed according to the invention. In this example, the first substrate W1 may have a comparatively low wafer bow and/or wafer warpage prior to the conditioning C as indicated by the schematic curved shape in fig. 1a. In this example, the plurality of local modifications is applied within the first Wafer W1 as a conditioning step C such that the shape/geometry of the first wafer W1 is transformed via bending from its originally flat shape/geometry to a substantially curved (or bend) shape/geometry. For example, the plurality of local modifications D may be applied such that the wafer bow and/or wafer warpage of the first wafer W1 is increased after the conditioning C.

In an example, the plurality of local modifications D may be adapted as described herein to evoke a predetermined first target geometry (e.g., a first target shape) of the first wafer W1.

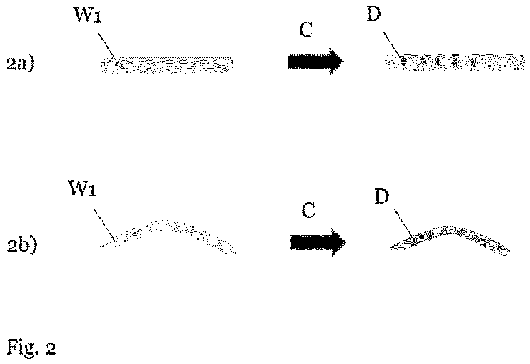

Fig. 2 shows two examples for a conditioning of a substrate via local modifications according to the invention wherein the conditioning evokes a positioning correction of a structure of the substrate as a conditioning effect. As indicated by the fig. 2a the conditioning C may not necessarily be performed to evoke a bending (or transformation of a shape) of the first wafer W1. Thus, after a conditioning C the wafer bow and/or wafer warpage of the first wafer W1 may be substantially the same. In the example of fig. 2 the conditioning C of the first wafer W1 may be performed such that a positioning correction (e.g., an overlay error correction) of one or more structures on the first wafer may be induced. Hence, the conditioning may comprise shifting structures along one or more axes. The position correction may be implemented in view of a further processing of the first wafer W1, for example, a bonding of the first wafer W1 to a second wafer W2 (as described herein).

Notably, the conditioning effect described for fig. 1 may be combined with the conditioning effect described for fig. 2. Thus, a conditioning according to the invention may induce a bending of the first wafer W1, as well as a position correction of structures of the first wafer W1.

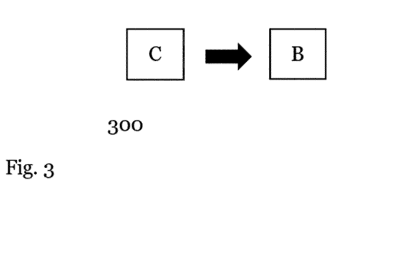

Fig. 3 shows a flow chart of an exemplary (conditioning) method 300 of the invention wherein the conditioning is performed as a pre-conditioning for a bonding of substrates. As schematically illustrate the method may comprise a conditioning C (e.g., of the first wafer W1 and/or a second wafer W2) and a subsequent bonding of the first wafer W1 to the second wafer W2.

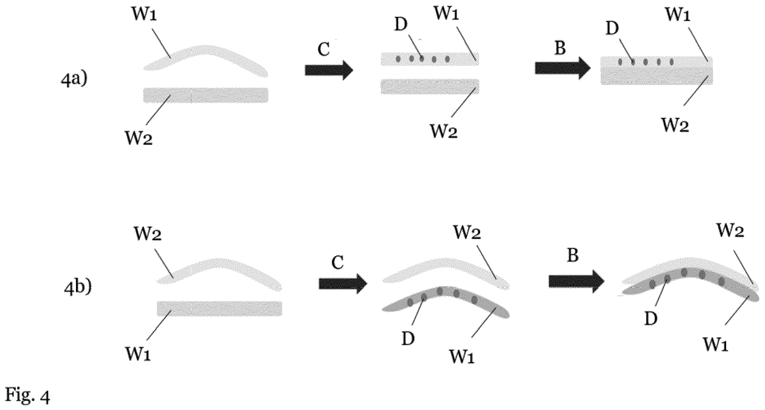

Fig. 4 shows two examples for a pre-conditioning of substrates for a bonding of the substrates.
Fig. 4a and 4b show a pre-conditioning example, wherein a first wafer W1 is for bonding to a second wafer W2. First a conditioning step C takes place followed by a bonding process B of the first wafer W1 and the second wafer W2.

In the first pre-conditioning example of fig. 4a, originally the shape of the first wafer W1 may be a substantially curved (or bend) shape. The shape of the second wafer W2 may be a substantially flat shape. For example, originally the wafer bow and/or wafer warpage of the first wafer W1 may be higher than the wafer bow and/or wafer warpage of the second wafer W2. The pre-conditioning may comprise that the shape (or wafer bow/warpage) of the (curved) first wafer W1 is substantially matched to the shape (or wafer bow/warpage) of the (flat) second wafer W2.

In the first pre-conditioning example of fig. 4a the plurality of local modifications D can be applied to the first wafer W1 to transform the shape of the first wafer W1 from its original (curved) shape to a first target geometry. For example, the conditioning C of the first wafer W1 may evoke that the first wafer transforms to a substantially flat shape such that both wafers W1, W1 have a substantially flat shape. In another example, the method may comprise that after a conditioning C of the first wafer W1 both wafers W1, W2 have substantially the same wafer bow and/or wafer warpage. In another example, the method may comprise that after conditioning C two or more corresponding points of the first wafer W1 and the second wafer W2 have substantially the same (local) deviation from a wafer reference plane. For example, the points may be addressed via wafer coordinates (x,y).

In the second pre-conditioning example of fig. 4b, originally the shape of the first wafer W1 may be a substantially flat shape. The shape of the second wafer W2 may be a substantially curved (or bend) shape. For example, originally the wafer bow and/or wafer warpage of the first wafer W1 may be lower than the wafer bow and/or wafer warpage of the second wafer W2. The pre-conditioning may comprise that the shape (or wafer bow/warpage) of the (curved) first wafer W1 is substantially matched to the shape (or wafer bow/warpage) of the (flat) second wafer W2.

In the pre-conditioning example of fig. 4b the plurality of local modifications D can be applied to the first wafer W1 to transform the shape of the first wafer W1 from its original (flat) shape to a first target geometry. For example, the conditioning C of the first wafer W1 may evoke that the first wafer W1 transforms to a substantially curved (or bend) shape such that both wafers W1, W1 have a substantially curved (or bend) shape. In another example, the method may comprise that after a conditioning C of the first wafer W1 both wafers W1, W2 have substantially the same wafer bow and/or wafer warpage. In another example, the method may comprise that after conditioning C two or more corresponding points of the first wafer W1 and the second wafer W2 have substantially the same (local) deviation from a wafer reference plane.

The herein described wafer shape adaption of a first wafer W1 in view of a characteristic of a second wafer W2 may be advantageous for a bonding B of the first wafer W1 to the second wafer W2. In the first pre-conditioning example, a bonding B may require arranging the wafers in a bonding position with the first wafer W1 being on top of the second wafer W2. In the second pre-conditioning example, a bonding B may require arranging the wafers in a bonding position with the second wafer W2 being on top of the first wafer W1. Without the herein described conditioning one or more (significant) gaps may be present in a bonding position as the wafer shapes of the first wafer W1 and the second wafer W2 would highly differ in their geometry (e.g., shape). Such a mismatch of wafer geometries may adversely affect the bonding process that usually exerts a high physical and/or mechanical stress on both wafers. The present invention may enable a wafer shape matching of the first and second substrate reducing the extent of geometric mismatches when the wafers are arranged in a bonding position to facilitate a bonding thereof. Hence, at least one bonding quality parameter may be improved via the inventive conditioning.

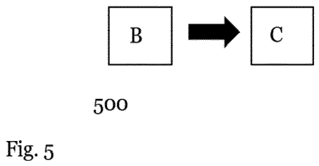

Fig. 5 shows a flow chart of an exemplary (conditioning) method 500 of the invention wherein the conditioning is performed as a post-conditioning after a bonding of substrates has occurred. As schematically illustrate the method may comprise a bonding B (e.g., of a first wafer W1 and a second wafer W2) and a subsequent conditioning of the first wafer W1 and/or the second wafer W2.

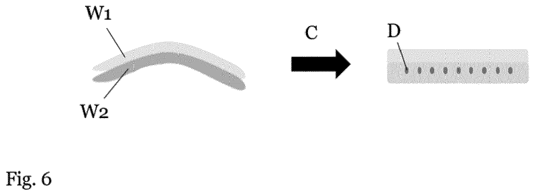

Fig. 6 shows an example for a post-conditioning of substrates according to the invention after a bonding of substrates has occurred. The initial starting point in this example is a first wafer W1 being bonded to a second wafer W2 such that a bonded wafer pair is formed. In the illustrated example, originally the bonded substrate pair corresponds to a substantially curved (or bend) shape. However, any shape (or geometry) of the bonded substrate pair may be adaptable or conditioned as described herein. According to the invention a conditioning C of the bonded wafer pair may comprise applying a plurality of local modifications within the first wafer W1 and/or second wafer W2. In this example, the modifications D are applied within the second wafer W2. To that regard, the conditioning C may evoke that the second wafer W2 transforms from its original shape to a (predetermined) target geometry. In this example, the target geometry of the second wafer comprises a substantially flat wafer shape. Moreover, the conditioning C may evoke that the second wafer W2 transforms from its original shape to a (predetermined) target geometry. The conditioning C may also evoke that the bonded substrate pair transforms from its original shape to a (predetermined) target geometry. As described herein, the target geometries and the effects of the local modifications may be determined via a simulation (e.g., a finite element simulation). For example, a simulation model may comprise a model of the first wafer W1 being bonded to the second wafer W2. By simulation various modifications within the first wafer W1 and/or second wafer W2 desired target geometries of the wafers and/or the bonded substrate pair may be determined.

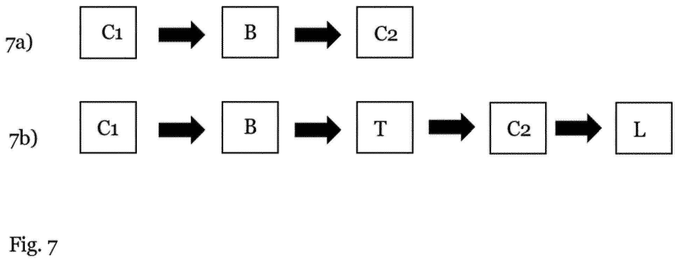

Fig. 7 shows a flow chart of two exemplary (conditioning) methods according to the invention wherein the conditioning of substrates is performed before and after a processing of the substrates (e.g., a bonding of the substrates). Hence, a method according to the invention may comprise performing a first conditioning C1 (e.g., as a pre-conditioning) and a second conditioning C2 (e.g., as a post-conditioning) via a plurality of local modifications within a substrate.

In the first example shown in fig. 7a the method may comprise a pre-conditioning C1 of a first and/or second wafer (as described herein) to facilitate a bonding thereof. Subsequently, the first and second Wafer W1, W2 may be bonded to each other via a bonding process B. Subsequently, a post-conditioning C2 of the bonded substrate pair (as described herein) may occur to facilitate the bonding (e.g., to improve the quality of the bond of the first and second wafer).

In the second example shown in fig. 7b the method may comprise a first conditioning C1 (e.g., a pre-conditioning) of a first and/or second wafer (as described herein) to facilitate a bonding thereof. Subsequently, the first and second Wafer W1, W2 may be bonded to each other via a bonding process B. Subsequently, a first further processing T of the bonded substrate pair may occur. The first further processing T may comprise a measurement of the bonded substrate pair. The first further processing T may also comprise a thinning of the bonded substrate pair, for example, via a (mechanical) grinding and/or an etching of a surface of the bonded substrate pair. Subsequently, a second conditioning C2 (e.g., a post-conditioning or pre-conditioning) of the bonded substrate pair (as described herein) may occur. The second conditioning C2 may be adapted as a post-conditioning to facilitate the bonding (e.g., to improve the quality of the bond of the first and second wafer). In another example, the second conditioning C2 may be adapted as a post-conditioning to improve the result or alleviate negative effects from the first further processing T (e.g., a grinding/etching may induce mechanical stress that may be alleviated via a conditioning as described herein). In another example, the second conditioning C2 may comprise a conditioning in view of a (subsequent) second further processing L of the bonded substrate pair. The second conditioning C may, for example, function as a pre-conditioning of the bonded substrate pair to facilitate the second further processing L. For example, the second further processing L may comprise a lithographic process (e.g., a lithographic patterning) of the bonded substrate pair. Notably, the second conditioning C2 may evoke a target geometry of the bonded substrate pair (or of at least one of its substrates) such that at least one lithographic parameter is improved compared to when no conditioning occurs. Notably, every aspect described for a conditioning process may be applied to the first and/or second conditioning C1, C2.

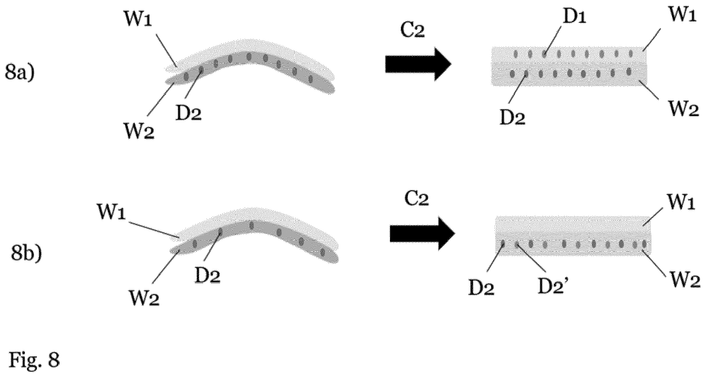

Fig. 8 shows a schematic example for a second conditioning C2 (e.g., a post-conditioning) of substrates according to the invention wherein a first conditioning (e.g., pre-conditioning) of the substrates already occurred. For example, a starting point of this exemplary method may comprise a first wafer W1 being bonded to a second wafer W2, wherein a plurality of local modifications D2 have been applied within the second wafer W2 (e.g., in a first conditioning C1).

In a first example 8a of Fig. 8 the second conditioning C2 may comprise applying the plurality of local modifications within the substrate that did not receive local modifications during the first conditioning C1. Hence, in this example, the second conditioning C2 may comprise applying local modifications D1 within the first wafer W1.

In a second example 8b of Fig. 8 the second conditioning C2 may comprise applying the plurality of local modifications within the substrate that already received local modifications during the first conditioning C1. Hence, in this example, the second conditioning C2 may comprise applying local modifications D2' within the second wafer W2. For example, the local modifications D2' applied with the second conditioning C2 may not overlap with the local modifications D2 applied with the first conditioning C1.

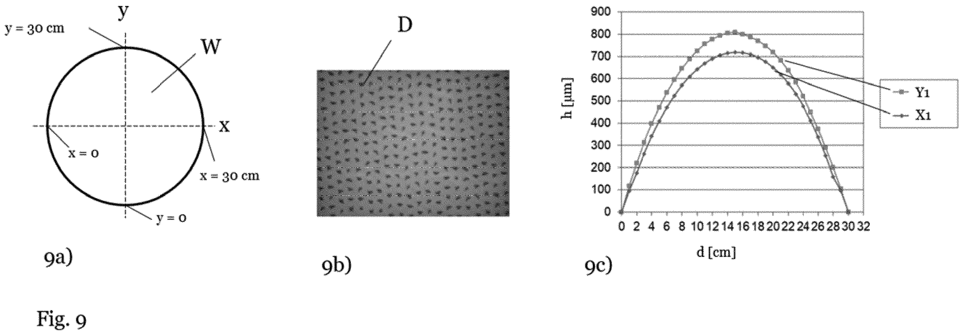

Fig. 9 shows experimental results of a conditioning of a substrate according to the invention. Subfigure 9a schematically shows a test wafer W and an according coordinate system with an x-axis and a y-axis. Subfigure 9b shows an optical image (an IR microscope image) of a plurality of local modifications D (i.e., pixels D as described herein) applied within the test wafer. In the experiment the pixels D were applied within the test wafer W such the bending of the test wafer W may bend in the x- and y-direction with substantially the same extent. As described herein, the pixels may be induced via focusing an electromagnetic radiation within the test wafer W wherein an optical property of the electromagnetic radiation (e.g., at its focus) may purposefully adapt a local modification parameter of a pixel.

Subfigure 9c shows a profilometric measurement of the surface of the test wafer W (having a diameter of 300 mm). The profilometric measurement results show the measured height along the x-axis of the test wafer W which is indicated via the height profile line X1. The profilometric measurement results also show the measured height along the y-axis of the test wafer W which is indicated via the height profile line Y1. Hence, the height profile line X1 shows the height distribution of the wafer in reference to its outer wafer edges at x = 0 cm and x = 30 cm. The height profile line Y1 shows the height distribution of the wafer in reference to its outer wafer edges at y = 0 cm and y = 30 cm. The height profile lines X1, Y1 may indicate a shape of the test wafer along the according axis since the measurement probe scans the wafer's surface and thus follows the outer shape of the wafer.

It can be seen that in both directions a substantial bending is induced wherein the bending is substantially the same along the two axes. Along the height profile line X1, it can be seen that the middle of the wafer (at x = 15 cm) is distributed about 700 µm above the respective reference edges (at x = 0 cm and x = 30 cm). Along the height profile line Y1, it can be seen that the middle of the wafer (at y = 15 cm) is distributed about 800 µm above the respective reference edges (at y = 0 cm and y = 30 cm).

Hence, the measured test wafer W of subfigure 9c corresponds to a convex shape.

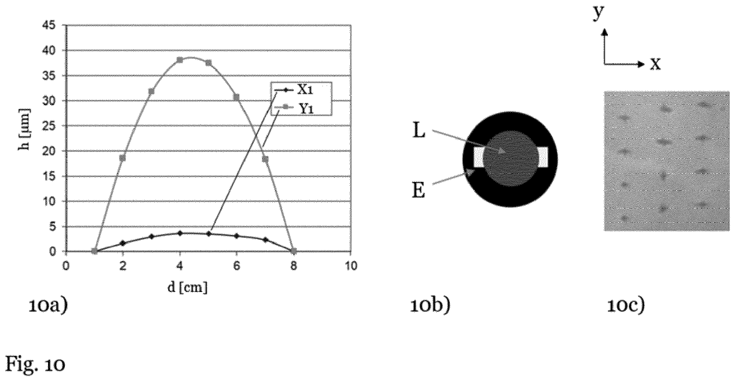

Fig. 10 shows further experimental results of a conditioning of a substrate according to the invention. Notably, in Fig. 10 the conditioning was applied to a test wafer with a diameter of 8 cm. Fig. 10 illustrates that the plurality of local modifications may be applied such that a bending of the wafer occurs along (substantially) one direction. As can be seen in Subfigure 10a the height profile line Y1 along a y-axis of the wafer indicates a significant bending along the y-axis. However, the height profile line X1 along an x-axis of the wafer (orthogonal to the y-axis) indicates a comparatively lower bending along the x-axis. This may be achieved by inducing pixels within the wafer that are aligned along the x-axis. Such pixels are shown in subfigure 10c. Notably, the pixels of subfigure 10 are micro strain elements which are aligned along the x-axis. Namely, it can be seen that the micro strain elements have an elongated form wherein the longer axis of the elongation extends along the x-axis and the shorter axis of the elongation extends along the y-axis. Hence, such a micro strain element (of the plurality of micro strain elements) may have a first local force acting along the y-axis that is higher than a second local force of the micro strain element that is acting along the x-axis. Hence, it may be evoked that the bending along the y-axis is higher than the bending along the x-axis.

For illustrative purposes, subfigure 10b indicates how an elongated form of the micro strain element may be generated. For example, the micro strain element may be induced via focusing electromagnetic radiation (e.g., of a laser) within the wafer. An according apparatus (as described herein) may thus control a laser beam L. Within the apparatus a diaphragm E may be present or adaptable to shape the laser beam L. In the example of subfigure 10 the diaphragm E may be an (adaptable) slit which may be controlled such that the longer axis of the opening is oriented along the x-axis. The diaphragm E may thus shape the laser beam L output such that the laser beam is focused in an elongated form within the wafer (e.g., along the x-axis) such that the micro strain elements are oriented along the x-axis. Notably, various other mechanisms for evoking a desired local modification parameter of a micro strain element with an optical setup are possible (as described herein).

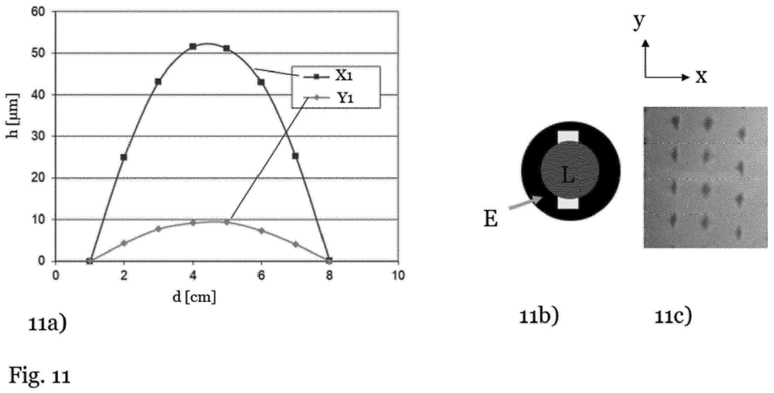

Fig. 11 shows further experimental results of a conditioning of a substrate according to the invention. Notably, in Fig. 10 the conditioning was applied to a test wafer with a diameter of 8 cm. Fig. 11 illustrates (just as Fig. 10) that the plurality of local modifications may be applied such that a bending of the wafer occurs along (substantially) one direction. However, in Fig. 11, the pixels were adapted such that the bending occurs substantially along the x-axis of the wafer as indicated by the height profile line X1. Notably, the pixels are shown in subfigure 11 wherein the micro strain elements are aligned along the y-axis. Hence, such a micro strain element (of the plurality of micro strain elements) may have a first local force acting along the x-axis that is higher than a second local force of the micro strain element that is acting along the y-axis. Hence, it may be evoked that the bending along the x-axis is higher than the bending along the y-axis.

For illustrative purposes, subfigure 11b indicates how an elongated form of the micro strain element may be generated to induce the pixels of subfigure 11. As illustrated for fig. 10 an apparatus for generating the pixels may comprise a diaphragm E for shaping a laser beam L that is focused within the wafer. In the example of subfigure 11 the diaphragm E may also be an (adaptable) slit wherein the slit may be controlled such that the longer axis of the opening is oriented along the y-axis. The diaphragm E may thus shape the laser beam L output such that the laser beam is focused in an elongated form within the wafer (e.g., along the y-axis) such that the micro strain elements are oriented along the y-axis. Notably, various other mechanisms for evoking a desired local modification parameter of a micro strain element with an optical setup are possible (as described herein).

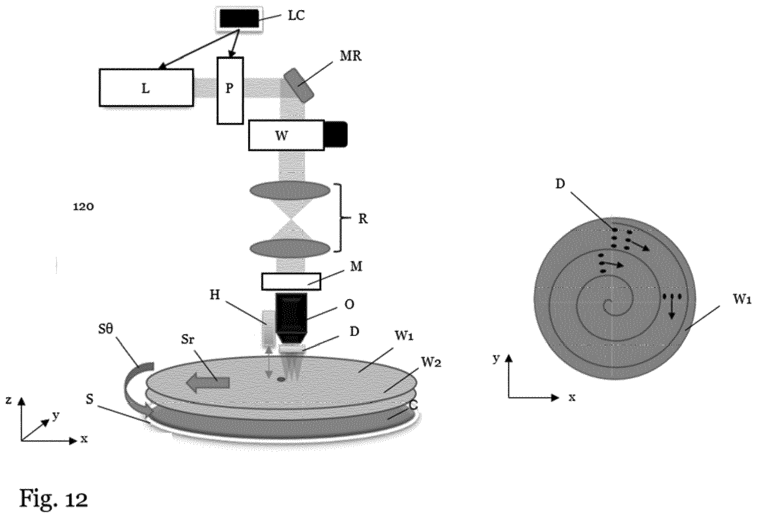

Fig. 12 shows a first example of an apparatus 120 according to the invention. The apparatus may be configured to perform a herein described method. The main principle of the apparatus is that a laser beam is focused within the substrate such that a local reaction is evoked that causes a defined local modification (i.e., a pixel).

The apparatus 140 may comprise a laser unit L. The laser unit L may comprise a laser that may be controlled to output laser pulses along a laser beam direction. The laser may comprise a laser with a herein described wavelength. Notably, the laser may also comprise any other type of laser in the infrared range (with a wavelength between 700 nm and 1 mm).

In an example, the laser energy may comprise an energy between 1 µJ and 100 µJ. In an example, the laser power may comprise a power between 40 W and 200 W.

The apparatus 120 may further comprise a pixel modulator P. The pixel modulator P may comprise an acousto-optic modulator. The pixel modulator P may modulate whether the incoming laser beam from the laser unit L is coupled into the main beam path of the apparatus. For example, the pixel modulator P may guide the incoming laser beam such that it is not coupled to the main optical path of the apparatus. In an example, the pixel modulator P may evoke a blanking of the incoming laser beam such that the laser beam is not coupled to the main beam path (e.g., via an absorption of the laser beam light). The pixel modulator P may enable a control whether a laser beam focus that evokes a pixel within the substrate is applied within the substrate or not. The laser unit L and the pixel modulator P may be controlled via a laser control unit LC. The laser control unit LC may comprise a laser gate control unit.

Subsequently, optical elements along the main optical path of the laser are explained that may be controlled in a purposeful manner to adapt a local modification parameter of a pixel within a substrate.

In an example, the main optical path may comprise a deflecting mirror MR to deflect the laser beam coming from the pixel modulator P (e.g., for spatial design purposes).

The main path may further comprise a waveform manipulator W. The waveform manipulator W may be controllable to adapt the shape of the waveform of the laser beam wavefront. In an example, the waveform manipulator may be controllable to induce a desired astigmatism of the laser beam. For example, the waveform manipulator W may be controllable to induce an astigmatism along a certain orientation. This may enable the adapt the orientation of the pixels (as described herein). The waveform manipulator W may, for example, comprise a spatial light modulator (SLM). The spatial light modulator may comprise a liquid crystal on silicon (LCoS SLM). In an example, the waveform manipulator W may comprise an optical unit that may adapt the waveform of the laser beam (e.g., by inducing a desired astigmatism). In an example, the waveform manipulator W may comprise a waveform control unit (wherein the waveform control unit may comprise a motor to adapt the waveform manipulator).

The optical path may further comprise a relay unit R. The relay unit R may comprise two or more lenses. The relay unit R may be configured to function as telescope. For example, a focus of a first lens of the relay unit R may be positioned within a focus of a second lens of the relay unit R.

The optical path may further comprise a multi beam unit M. The multi beam unit M may function to generate two or more partial beams out of the incoming laser beam. For example, the multi beam unit M may comprise a diffractive optical element (DOE). The diffractive optical element may comprise a diffraction grating. The diffraction grating may comprise a transmissive and/or reflective grating. In an example, the multi beam unit M may comprise a wavefront manipulator (e.g., a spatial light modulator). In an example, the multi beam unit M and the wavefront manipulator W may be realized via one optical element (e.g., a wavefront manipulator in the form of a spatial light modulator). In the example, of fig. 12, the multi beam unit M is adapted to generate three spatially separated beams out of the incoming laser beam. Hence, three focus points may be generated within the processed substrate (as indicated in fig. 12) for one laser shot. In turn, a set of three pixels may thus be applied within the substrate simultaneously in this example. A shot may comprise one or more laser pulses coming out of the laser unit L such that enough energy/power is applied within the substrate to generate at least one pixel. The multi beam unit M may be configured to generate at least four partial beams (thus **4** pixels with one shot), at least 8 partial beams (thus 8 pixels with one shot), at least 10 partial beams (thus 10 pixels) with one shot. It may also be conceivable the generate up to 100, 200, 300 and/or 500 pixels within one shot.

In another example, the multi beam unit M may function to scan the incoming laser beam onto predetermined scan positions within the substrate. For example, the multi beam unit M may comprise a scanning unit (e.g., an acousto-optic deflector, AOD, a spatial light modulator, a galvanometer scanner, etc.). To illustrate an example, the multi beam unit may be configured to deflect the incoming laser beam onto three predetermined scan positions within the substrate. This may enable to evoke three local modifications within a spatial area/volume of the substrate within a scan window time. For example, the scanning unit may deflect the incoming laser beam onto a first scan position. Subsequently, a first pixel may be written onto the first scan position. Thereafter, the scanning unit may deflect the incoming laser beam to a second scan position. Subsequently, a second pixel may be written onto the second scan position. This may be repeated for the third scan position. The scan window time may comprise the time in which the entire processing for the first, second and third scan position has occurred.

The optical path may further comprise a focusing unit O. The focusing unit O may comprise a telecentric lens unit. However, any other suitable optics may be used as a focusing unit O. The focusing unit O may be moveable (e.g., via a mechanical stage) to adapt a focusing depth of the laser beam. Hence, the focusing unit O may be used to focus the laser beam onto a predetermined focusing depth within the substrate. The optical unit O may be configured such that the optical quality of the laser beam is minimized for a predetermined system focusing depth within the substrate (e.g., if no further compensation is made to the laser beam and/or its wavefront). For example, the optical quality may comprise a root-mean-square (RMS) wavefront error.

The optical path may further comprise a depth compensation unit D. The depth compensation unit D may be controllable to compensate an undesired optical effect that may arise from focusing the laser beam onto a focusing depth different from the predetermined system focusing depth. The depth compensation unit D may comprise a wavefront manipulator. The depth compensation unit D may comprise an optical medium. The optical medium may be positioned via the apparatus (e.g., along the main optical paths optical axis) for a depth compensation. In another example, the apparatus may control the refractive index of the optical medium.

In an example, the depth compensation unit D may be comprised by the wavefront manipulator W. Hence, the wavefront manipulator may implement the depth correction (e.g., via shaping the wavefront).

Furthermore, the apparatus 120 may comprise a height sensor H. The height sensor may measure the height from a reference point to the (upper) surface of the substrate which is processed in the apparatus. The height may correspond to a distance parallel to the optical axis of the optical main path of the apparatus. For example, the height sensor may measure a distance between the focusing unit O and the (upper) surface of the substrate). The apparatus may be configured to receive the height from the height sensor H and adapt a focusing of the laser beam accordingly.

Moreover, the apparatus 120 may comprise a stage S. The stage S may be configured to secure a (e.g., removable) chuck C. The chuck C may be configured to securely hold a substrate (e.g., a wafer). In another example, the chuck may be configured to securely hold a bonded substrate pair (e.g., a bonded wafer pair). In fig. 12 a first wafer W1 is shown that is bonded to a second wafer W2 wherein the chuck C may securely hold the bonded wafer pair.

The chuck C may comprise an electrostatic chuck, a vacuum chuck and/or a combination thereof. The chuck C may also comprise a contactless chuck, a side grip chuck (or combinations thereof). Furthermore, the chuck C may also be a transparent chuck. The stage S and the chuck C may be coupled such that they form a positioning unit. Hence, if the stage S moves the chuck C moves accordingly (and/or vice versa). Moreover, if the positioning unit moves also the substrate and/or the bonded substrate pair secured by the chuck C will move accordingly.

For example, the exemplary apparatus 120 may be configured to rotate the stage S such that the chuck C rotates to accordingly enable a rotational movement Sθ of the substrate and/or bonded substrate pair secured by the chuck C. For example, the stage S may comprise a R-Theta stage. The R-Theta stage may be configured for a rotational speed between 1000 rpm and 8000 rpm, preferably between 2000 rpm and 6000 rpm, more preferably between 2500 rpm and 5000 rpm, most preferably between 3000 rpm and 4000 rpm. This may enable a high throughput when processing the substrate according to the invention.

Moreover, the exemplary apparatus 120 may be configured such that the positioning unit (comprising stage S and chuck C) may be moved back and forth along a lateral axis. This may enable a lateral movement Sr of the substrate and/or bonded substrate pair secured by the chuck back and forth along the lateral axis.

The rotational movement Sθ and lateral movement Sr may enable to apply the plurality of local modifications in a spiral pattern within a substrate. A method as described herein, may thus be performed simply via a rotational movement and a lateral movement (back and forth along one axis) of the substrate which may reduce system complexity.

The spiral pattern application enabled by the configuration of the positioning unit is shown on the right subfigure of figure 12. An exemplary method is shown, wherein the apparatus 120 applies local modifications within the first wafer W1. As stated in an example, the apparatus 120 may apply a set of three pixels (i.e., three local modifications D) simultaneously. Via the rotational movement Sθ a plurality of sets of pixels may thus be applied circumferentially along a radius the first wafer W1. Via the lateral movement Sr radius onto which the sets of pixels are applied may be varied. Notably, via the lateral movement Sr the sets of pixels may be applied in a spiral pattern as is visualized in fig. 12.

Notably, in an example, the positioning unit (stage S and chuck C) of the apparatus 120 may be also configured for a lateral movement along two or more lateral axes (e.g., along the indicated x- and y-axis). In another example, the positioning unit may also be configured for a vertical movement (e.g., along the optical axis of the apparatus). Regardless of the configuration of the positioning unit the apparatus may be configured to only activate the capabilities of the rotational movement and/or the lateral movement to perform the mentioned spiral pattern application.

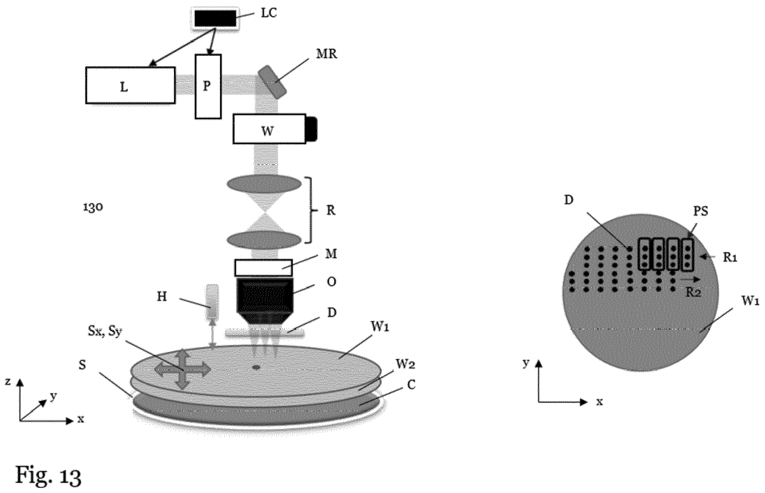

Fig. 13 shows a second example of an apparatus 130 according to the invention. The apparatus may be configured to perform a herein described method. Every aspect/feature described for the apparatus 120 (of the first example) may be applied to the apparatus 130 of the second example. For example, the apparatus 130 may comprise all the features described for the apparatus 120.

However, in the illustrated example of the apparatus 130 of fig. 13 the positioning unit comprising the stage S and the chuck C may be configured such that a movement along two or more lateral axes may be evoked for the substrate and/or substrate pair. In an example, the positioning unit may be configured for a lateral movement along an x-axis (Sx) and a lateral movement along a y-axis (Sy) wherein the y-axis may be orthogonal to the x-axis. In the shown exemplary apparatus 130 the multi beam unit M may be an optical element that functions to generate three partial beams (simultaneously) out of the incoming laser beam. (For example, the multi beam unit M of the apparatus 130 may comprise a beam splitter, e.g., a DOE.) Hence, the apparatus may be configured to apply a pixel set PS of three pixels simultaneously within a substrate.

By controlling the stage S along the x-axis and the y-axis a plurality of pixel sets PS may be arranged next to each other (e.g., in a rectangular pattern) over the entire substrate (e.g., within a first wafer W1 as shown). The right subfigure of fig. 13 shows an arrangement of various pixel sets PS having each three pixels applied to the first wafer W1. The pixel sets PS may be applied in a line scanning manner. For example, starting from a substrate edge the pixel sets may be applied in a line along direction R1 (parallel to the x-axis) until the other end/edge of the substrate is reached. Subsequently, the stage may be offset along the y-axis to enable generating the pixels sets on another line along a direction R2 (parallel to the x-axis). This may be repeated to generate pixels over the entire substrate.

Notably, every feature described for the apparatus 140 may be comprised by the apparatus 130 of the first example.

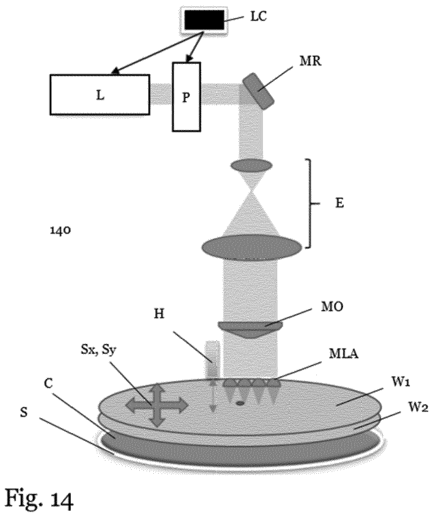

Fig. 14 shows a third example of an apparatus 140 according to the invention. The apparatus may be configured to perform a herein described method. The optical setup of the apparatus may also comprise a laser unit L, a pixel modulator P, a laser control unit LC and a deflective mirror MR arranged within an optical path of the laser beam just as the apparatus 130 and apparatus 140. The apparatus 140 may also comprise a stage S and a chuck C. The apparatus 140 may be configured to control the stage s (and thus the substrate secured on the chuck C) as described for apparatus 130 (and/or apparatus 120).

However, the further optics and/or optical elements of the apparatus 140 may differ.

For example, the optical main path of the apparatus 140 may comprise a beam expander E (as shown in fig. 14). The beam expander E may comprise two lenses. The two lenses may be arranged such that a focus of a first lens is positioned within a focus of a second lens of the beam expander. The lenses may have further optical characteristics or elements such that the incoming laser beam is expanded (and preferably collimated) at the output of the beam expander.

The optical main path of the apparatus 140 may further comprise a micro lens array MLA. The incoming (e.g., expanded) laser beam may be adapted by the micro lens array MLA such that multiple foci can be generated within a substrate that is positioned within the apparatus. In the example, of the apparatus 140 the micro lens array MLA comprises a one-dimensional micro lens array having four micro lenses arranged along a line. However, the number of micro lenses of the micro lens array may not be limited according to the invention. In another example, the micro lens array MLA comprises a two-dimensional micro lens array. Hence, this may enable generating multiple foci simultaneously along a focusing plane within the substrate.

In an example, the two-dimensional micro lens may be configured such that its according foci substantially cover the entire substrate. For example, the substrate may be processed within one shot (as all pixels to be applied to the substrate may be induced simultaneously). In another, example, the apparatus 140 may comprise a scanning unit for deflecting the laser beam onto one or more micro lenses of the micro lens array MLA. Hence, a subset of the possible foci of the micro lens array MLA may be generated within one shot.

The optical main path of the apparatus 140 may further comprise a micro lens coupling unit MO. For example, if the micro lens array MLA comprises a one-dimensional micro lens array the micro lens coupling unit MO may comprise a powell lens. The powell lens may be configured to fan out the incoming laser beam such that a coupling thereof to the one-dimensional micro lens array can be facilitated.

For example, if the micro lens array MLA is a two-dimensional micro lens array the micro lens coupling unit MO may comprise a collimator lens. The collimator lens may be configured such that the laser beam is coupled to the two-dimensional micro lens array (or a subset of micro lenses thereof) in a defined manner.

In an example, the apparatus 140 may also comprise a wavefront manipulator W, a multi beam generator M, and/or a depth compensation unit (as outlined for apparatus 120 and apparatus 130).

Notably, an apparatus according to the invention may be configured such that a total writing time of the pixels over the entire substrate is below 30 s, preferably below 20 s, more preferably below 15 s, most preferably below 12 s. This may be enabled by the herein described parallel approaches where pixels may be generated simultaneously.

In an example, the herein described apparatuses (and/or their focusing unit O and/or the micro lens coupling unit MO) may have a numerical aperture within a range of 0.55 and 0.85.

Notably, an apparatus according to the invention may comprise a control unit (as described herein) for enabling a precise control of its components (e.g., optical elements) for performing a herein described method.

In the following further examples of the invention are described.

Example 1: Method for conditioning a bonding of substrates comprising:
applying a plurality of local modifications within a first substrate for facilitating bonding the first substrate to a second substrate.

Example 2: Method according to example 1, wherein the applying of the plurality of local modifications within the first substrate is further based at least in part on a characteristic of the second substrate and/or of the first substrate.

Example 3: Method according to example 1 or 2, wherein the applying of the plurality of local modifications within the first substrate is adapted to evoke a first target geometry of the first substrate.

Example 4: Method according to example 3, wherein the first target geometry is predetermined such that if the first and second substrate are bonded, at least one bonding quality parameter is improved compared to when no conditioning occurs.

Example 5: Method according to examples 3 or 4, wherein the first target geometry is based at least in part on a predetermined geometry of the second substrate.

Example 6: Method according to example 5, wherein the predetermined geometry of the second substrate comprises a global geometry of the second substrate.

Example 7: Method according to example 6, wherein the global geometry of the second substrate comprises a surface topography and/or one or more deviations of the second substrate from a substrate reference plane.

Example 8: Method according to any of examples 1-7, further comprising applying a plurality of local modifications within the second substrate.

Example 9: Method according to example 8, wherein the applying of the plurality of local modifications within the second substrate is adapted to evoke a second target geometry of the second substrate.

Example 10: Method according to example 9, wherein the second target geometry is predetermined such that if the first and second substrate are bonded, at least one bonding quality parameter is improved compared to when no conditioning occurs.

Example 11: Method according to example 9 or 10, referred back to any of examples 3-7, wherein the second target geometry is based at least in part on the first target geometry or vice versa.

Example 12: Method according to any of examples 3-11, further comprising sending a target geometry of at least one of the substrates to a device for further processing of at least one of the substrates, particularly a bonding device for bonding first and second substrates.

Example 13: Method according to any of examples 1-12, wherein the applying the plurality of local modifications within the first and/or second substrate is adapted such that, when the first and second substrates are arranged in a bonding position, at least one local bonding area of the first substrate and a corresponding local bonding area of the second substrate have substantially a same curvature.

Example 14: Method according to any of examples 1-13, wherein the applying the plurality of local modifications within the first and/or second substrate is adapted such that, when the first and second substrates are arranged in a bonding position, a structure of the first substrate is substantially aligned to a corresponding structure of the second substrate.

Example 15: Method according to any of examples 1-14, wherein the applying the plurality of local modifications within the first substrate is adapted to evoke a position correction of least one structure of the first substrate.

Example 16: Method according to any of examples 1-15, wherein the applying the plurality of local modifications comprises applying one or more pulses of electromagnetic radiation to the corresponding substrate to cause the corresponding plurality of local modifications within that substrate.

Example 17: Method according to any of examples 1-16, wherein the conditioning is performed before the bonding of the first and second substrates occurs.

Example 18: Method according to any of examples 1-17, wherein the conditioning is performed after the bonding of the first and second substrates has occurred.

Example 19: Method according to any of examples 1-18, further comprising the step of bonding the first and second substrates.

Example 20: Method for conditioning a first substrate, the method comprising: receiving a second characteristic of a second substrate;
determining a plurality of local modifications to be applied within the first substrate based at least in part on the second characteristic.

Example 21: The method of example 20, further comprising:
receiving a first characteristic of the first substrate;
determining the plurality of local modifications to be applied within the first substrate to facilitate bonding of the first and second substrates based at least in part on the first characteristic and the second characteristic.

Example 22: Method according to example 20 or 21, further comprising deriving a first target geometry of the first substrate to facilitate bonding of the first and second substrates,
wherein the plurality of local modifications to be applied within the first substrate are determined to evoke the first target geometry for the first substrate.

Example 23: Method according to any of examples 20-22, further comprising deriving a second target geometry of the second substrate to facilitate bonding of the first and second substrates,
wherein the plurality of local modifications to be applied within the second substrate are determined to evoke the second target geometry for the second substrate.

Example 24: Computer program comprising instructions for performing the method according to any of the examples 1-23, when the computer program is executed.

Example 25: Apparatus for conditioning a bonding of substrates comprising:
means for applying a plurality of local modifications within a first substrate for facilitating bonding of the first substrate to a second substrate;
a control unit configured to control the apparatus to perform a method of any of examples 1-23.

Example 26: Apparatus according to example 25, wherein the control unit is configured to receive information that the first substrate is for bonding to the second substrate and to control the apparatus to perform the method based at least in part on the information.

Example 27: Apparatus according to example 25 or 26, wherein the means for applying comprises:
a source for generating one or more pulses of electromagnetic radiation;
a first element for focusing a beam of the electromagnetic radiation onto a predetermined focusing depth within the first substrate.

Example 28: Apparatus according to any of examples 25-27, wherein the apparatus further comprises means for positioning the first substrate to control a local position of at least one local modification of the plurality of local modifications wherein the positioning comprises a rotation of the first substrate.

Example 29: Apparatus according to example 28, wherein the means for positioning is configured to position a bonded substrate pair comprising the first substrate being bonded to the second substrate.

Example 30: Apparatus for conditioning a first substrate, the apparatus comprising: means for receiving a second characteristic of a second substrate;
means for determining a plurality of local modifications to be applied within the first substrate based at least in part on the second characteristic.

Example 31: Apparatus according to any of examples 25-30, further comprising a memory storing the computer program of example 24.

## Claims

1. Method for conditioning a bonding of substrates comprising:
applying a plurality of local modifications within a first substrate for facilitating bonding the first substrate to a second substrate.

2. Method according to claim 1, wherein the applying of the plurality of local modifications within the first substrate is further based at least in part on a characteristic of the second substrate and/or of the first substrate.

3. Method according to claim 1 or 2, wherein the applying of the plurality of local modifications within the first substrate is adapted to evoke a first target geometry of the first substrate.

4. Method according to claim 3, wherein the first target geometry is predetermined such that if the first and second substrate are bonded, at least one bonding quality parameter is improved compared to when no conditioning occurs.

5. Method according to claims 3 or 4, wherein the first target geometry is based at least in part on a predetermined geometry of the second substrate.

6. Method according to claim 5, wherein the predetermined geometry of the second substrate comprises a global geometry of the second substrate.

7. Method according to claim 6, wherein the global geometry of the second substrate comprises a surface topography and/or one or more deviations of the second substrate from a substrate reference plane.

8. Method according to any of claims 1-7, further comprising applying a plurality of local modifications within the second substrate.

9. Method according to claim 8, wherein the applying of the plurality of local modifications within the second substrate is adapted to evoke a second target geometry of the second substrate.

10. Method according to claim 9, wherein the second target geometry is predetermined such that if the first and second substrate are bonded, at least one bonding quality parameter is improved compared to when no conditioning occurs.

11. Method according to any of claims 1-10, wherein the applying the plurality of local modifications within the first and/or second substrate is adapted such that, when the first and second substrates are arranged in a bonding position, at least one local bonding area of the first substrate and a corresponding local bonding area of the second substrate have substantially a same curvature.

12. Method according to any of claims 1-11, wherein the applying the plurality of local modifications comprises applying one or more pulses of electromagnetic radiation to the corresponding substrate to cause the corresponding plurality of local modifications within that substrate.

13. Computer program comprising instructions for performing the method according to any of the claims 1-12, when the computer program is executed.

14. Apparatus for conditioning a bonding of substrates comprising:
means for applying a plurality of local modifications within a first substrate for facilitating bonding of the first substrate to a second substrate;
a control unit configured to control the apparatus to perform a method of any of claims 1-12.

15. Apparatus according to claim 14, wherein the apparatus further comprises means for positioning the first substrate to control a local position of at least one local modification of the plurality of local modifications wherein the positioning comprises a rotation of the first substrate,
wherein the means for positioning is configured to position a bonded substrate pair comprising the first substrate being bonded to the second substrate.
